# EUROPÄISCHE PATENTANMELDUNG

(11) **EP 3 285 296 A1**
(43) Veröffentlichungstag der Anmeldung: **21.02.2018**
(21) Anmeldenummer: 16184428.7
(22) Anmeldetag: 17.08.2016
(51) Int. Cl.: H01L 25/07, H01L 25/065, H01L 25/18, H01L 25/10, H01L 25/11, H01L 23/495, H01L 23/34, H01L 25/16

(54) **LEISTUNGSMODUL UND VERFAHREN ZUR HERSTELLUNG EINES LEISTUNGSMODULS**

(71) Anmelder: Siemens Aktiengesellschaft, 80333 München (DE)
(72) Erfinder: Weidner, Karl, 81245 München (DE); Kiefl, Stefan, 80992 München (DE)

(57) **Zusammenfassung**

Das Leistungsmodul ist mit mindestens einem Leistungsbauteil (40) und einem Leiterrahmen (55) und einer Steuereinrichtung (95) gebildet, wobei der Leiterrahmen (55) ein Flachteil mit zwei Flachseiten umfasst und wobei das Leistungsbauteil (40) an einer der beiden Flachseiten und die Steuereinrichtung (95) an der anderen der beiden Flachseiten angeordnet ist.

## Beschreibung

Die Erfindung betrifft ein Leistungsmodul und ein Verfahren zur Herstellung eines Leistungsmoduls.

In der Leistungselektronik werden bei Leistungsmodulen die Baugrößen kontinuierlich reduziert. Gleichzeitig nehmen Integrationsgrad und Funktionalität zu. Dafür sind neuartige Aufbau- und Verbindungstechniken (AVT) erforderlich.

Gegenwärtig werden bei Leistungsmodulen Leistungshalbleiter auf einem DCB (DCB = engl. *"direct copper bonded")* aufgebaut und mit Hilfe von Bonddrähten elektrisch verbunden. Der Aufbau wird etwa auf eine Bodenplatte gelötet, in ein Gehäuse eingebracht und mit Silikon vergossen.

Zunehmend werden neben Silizium-Leistungshalbleitern SiC- und GaN-Wide-Band-Gap-Leistungshalbleiter (WBG-Leistungshalbleiter) eingesetzt, insbesondere in Spannungsbereichen von 1,2kV bis > 6,5kV, da die bei der Leistungsumwandlung entstehenden Verluste erheblich reduziert werden müssen.

Allerdings werden solche Leistungsbauteile mit Wide-Band-Gap-Leistungshalbleitern bislang nur unzureichend genutzt, da Leistungsbauteile, die grundsätzlich 1200V sperren können, aus Gründen der Entwärmung, Zuverlässigkeit und Induktivität tatsächlich nur bei 800V betrieben werden. Zudem wird der Schaltvorgang bewusst verlangsamt, damit die Schaltüberspannung abnimmt. Dies führt zu höheren Schaltverlusten der Halbleiter und somit zu einer geringeren Effizienz der Schaltung.

Unterschiedliche thermische Ausdehnungskoeffizienten (CTE) führen ferner zu mechanischen Spannungen und verringerter Zuverlässigkeit.

Bei höheren Betriebstemperaturen (>200°C) hingegen (etwa WBG-Leistungshalbleiter mit hohen Schaltfrequenzen) sind die üblichen Entwärmungssysteme nur bedingt geeignet und wenig zuverlässig.

Im unteren Leistungsbereich werden im Allgemeinen diskrete Bauelemente auf einer Leiterplatte (PCB: engl. *"Printed Circuit Board"*) miteinander verschaltet. Solche Schaltungen weisen sehr gute elektrische Eigenschaften auf (geringe parasitäre Induktivitäten). Dieses Vorgehen ist im höheren Leistungsbereich nicht mehr möglich, da hier die Verlustleistungen so groß werden, dass diese nicht mehr über eine Leiterplatte abführbar sind.

Es kommen daher Leistungsmodule auf DCB-Basis zum Einsatz. Allerdings ist die elektrische Verschaltung der Leistungsbauteile nur bedingt flexibel, was zu hohen parasitären Induktivitäten und somit zu hohen Schaltüberspannungen führt. Damit eine Zerstörung des Leistungsbauteils durch diese Schaltüberspannungen verhindert wird, werde heute die Arbeitsspannung und die Steilheit der Schaltflanke entsprechend angepasst.

Es ist daher Aufgabe der Erfindung, ein vor dem Hintergrund des vorgenannten Standes der Technik verbessertes Leistungsmodul zu schaffen. Insbesondere soll das Leistungsmodul effizient betreibbar und hinreichend entwärmbar sein. Ferner soll das erfindungsgemäße Leistungsmodul vorzugsweise kostengünstig und zuverlässig sein. Zudem ist es Aufgabe der Erfindung, ein Verfahren zur Herstellung eines Leistungsmoduls anzugeben.

Diese Aufgabe der Erfindung wird mit einem Leistungsmodul mit den in Anspruch 1 angegebenen Merkmalen sowie mit einem Verfahren zur Herstellung eines Leistungsmoduls mit den in Anspruch 11 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße Leistungsmodul weist mindestens ein Leistungsbauteil sowie einen Leiterrahmen und eine Steuereinrichtung auf. Bei dem erfindungsgemäßen Leistungsmodul umfasst der Leiterrahmen ein Flachteil mit zwei Flachseiten. Dabei ist bei dem erfindungsgemäßen Leistungsmodul das Leistungsbauteil an einer der beiden Flachseiten und die Steuereinrichtung ist an der anderen der beiden Flachseiten angeordnet. Erfindungsgemäß sind Leistungsbauteile und Steuereinrichtung, also Logikbauteile, zum einen räumlich getrennt voneinander an verschiedenen Seiten des Leiterrahmens angeordnet. Gleichzeitig ist mittels des als Flachteil ausgebildeten Leiterrahmens eine hohe Flexibilität bei der elektrischen Verbindung des mindestens einen Leistungsbauteils mit der Steuereinrichtung sowie ggf. mehrerer Leistungsbauteile miteinander gewährleistet. Sowohl das mindestens eine Leistungsbauteil als auch die Steuereinrichtung sind grundsätzlich beliebig nahe an dem Leiterrahmen anordbar, sodass bei dem erfindungsgemäßen Leistungsmodul eine niederinduktive elektrische Verbindung des mindestens einen Leistungsbauteils einfach gewährleistet werden kann. Dies ermöglicht einen effizienten Betrieb insbesondere von Leistungsbauteilen, welche mit Wide-Bandgap-Halbleitern (WBG-Halbleitern) gebildet sind.

Die mögliche flexible elektrische Verbindung bei dem erfindungsgemäßen Leistungsmodul erlaubt zudem einen hohen Integrationsgrad bei kleinem Bauvolumen. Insbesondere lassen sich weitere Funktionalitäten mittels des erfindungsgemäßen Leistungsmoduls realisieren, etwa die Überwachung von Umgebungsbedingungen, Kommunikationseinrichtungen sowie Messvorrichtungen, insbesondere Sensoren.

Aus der erfindungsgemäß möglichen niederinduktiven elektrischen Verbindung resultieren zudem geringe Schaltüberspannungen, sodass eine verbesserte Ausnutzung von Leistungsbauteilen möglich ist. Schaltverlustleistungen werden deutlich verringert. Auch weitere Bestandteile des Leistungsmoduls, vorzugsweise ein oder mehrere Filter und/oder ein DC-Link, sind nah an dem zumindest einen Leistungsbauteil anordbar. Das Leistungsmodul ist folglich bei hohen Schaltfrequenzen und effizient betreibbar.

Aufgrund der beidseitigen Anordnung von Leistungsbauteil und Steuereinrichtung ist bei dem erfindungsgemäßen Leistungsmodul eine direkte Entwärmung ohne zusätzliche Verbindungsschichten leicht realisierbar. Zudem lässt sich erfindungsgemäß eine hohe Leistungsdichte erzielen. Ferner lässt sich beidseitig des Leiterrahmens bei dem Leistungsmodul ein Kühlkörper anordnen. Insbesondere können bei dem erfindungsgemäßen Leistungsmodul zu kühlende Leistungsbauteile räumlich zwischen dem Leiterrahmen und einem Kühlkörper angeordnet sein, sodass eine Entwärmung des Leistungsmoduls besonders effizient möglich ist.

Besonders vorteilhaft ist, dass bei dem erfindungsgemäßen Leistungsmodul die Aufbau- und Verbindungstechnik lot- und sinterfrei realisierbar ist. Folglich ist das Leistungsmodul mit hoher Zuverlässigkeit ausbildbar.

Bevorzugt ist bei dem erfindungsgemäßen Leistungsmodul das Leistungsbauteil mit und/oder in und/oder zu einem Gussteil des Leistungsmoduls vergossen und der Leiterrahmen ist an dem Gussteil angeordnet. Mittels dieses Gussteils werden das Leistungsbauteil und die elektrischen Verbindungen vorteilhaft mechanisch fixiert und eingehaust und es werden zweckmäßig Freiräume des Leistungsmoduls mit Isolationsmaterial gefüllt. Ein Silikonverguss ist erfindungsgemäß verzichtbar. Vorteilhaft folgt somit im Fehlerfall nicht notwendig eine Kontamination der Umgebung. Dennoch ist erfindungsgemäß aufgrund des Vergusses eine hohe Kriechstromfestigkeit gewährleistet.

Zweckmäßig wird das Leistungsbauteil mit oder zu einem solchen oder in ein solches Gussteil vergossen, welches mit einem wärmeleitfähigen, elektrisch hochisolierenden, hochtemperaturbeständigen Material gebildet ist. Besonders bevorzugt ist das Material mit einem Füllstoff versehen, welcher in seinem thermischen Ausdehnungskoeffizienten an jenen von weiteren, an das Material angrenzenden Teilen des Leistungsmoduls angepasst, geeigneterweise sogar angeglichen, ist.

Vorzugsweise ist bei dem erfindungsgemäßen Leistungsmodul ein Vergussmaterial des Gussteils bei 293 K und Normaldruck ein Festkörper.

Bei dem erfindungsgemäßen Leistungsmodul ist in einer bevorzugten Weiterbildung der Erfindung der Leiterrahmen mit Metall, insbesondere mit Kupfer, gebildet.

Vorzugsweise ist bei dem erfindungsgemäßen Leistungsmodul der Leiterrahmen mittels additiver Fertigung, insbesondere in Form von galvanischer Fertigung und/oder von Fertigung mittels Druckens und/oder mittels Sprühens, vorzugsweise an dem Gussteil nach dem vorhergehenden Anspruch, angeordnet. In dieser Weiterbildung lassen sich die elektrischen Verbindungen des Leiterrahmens zugleich sehr flach und zudem sehr flexibel und automatisiert ausbilden. Es versteht sich, dass der Begriff *"additive Fertigung"* im Rahmen dieser Anmeldung synonym mit dem Begriff *"generative Fertigung"* verwendet wird.

Besonders bevorzugt ist bei dem erfindungsgemäßen Leistungsmodul der Leiterrahmen mehrlagig aufgebaut. Mittels des mehrlagigen Leiterrahmens sind die Leistungsbauteile frei und definiert anordbar und gleichzeitig ist eine besonders hohe Flexibilität der elektrischen Verbindung gewährleistet.

Bei einer bevorzugten Weiterbildung des erfindungsgemäßen Leistungsmoduls weist das Flachteil des Leiterrahmens eine Dicke von höchstens 500 Mikrometern, vorzugsweise von höchstens 200 Mikrometern, insbesondere von höchstens 70 Mikrometern auf. Mittels eines solch dünnen Leiterrahmens sind Leistungsbauteile und Steuereinrichtung räumlich trennbar und zugleich mit extrem kurzen elektrischen Verbindungswegen und folglich besonders niederinduktiv verbindbar.

Bevorzugt ist das erfindungsgemäße Leistungsmodul bodenplattenlos ausgebildet. Mittels des erfindungsgemäß vorgesehenen Leiterrahmes ist eine hinreichend flexible elektrische Verbindung von Leistungsbauteilen möglich, sodass eine Bodenplatte bei dem erfindungsgemäßen Leistungsmodul verzichtbar ist.

Das erfindungsgemäße Leistungsmodul benötigt keine Substrate, insbesondere keine DCB- und PCB-Substrate. Zweckmäßig ist das erfindungsgemäße Leistungsmodul daher DCB-substratfrei und/oder PCB-substratfrei, vorzugsweise substratfrei, ausgebildet.

Vorzugsweise weist das erfindungsgemäße Leistungsmodul mindestens einen Kühlkörper auf, welcher thermisch an zumindest eine Flachseite des Flachteils des Leiterrahmens angebunden ist.

Die erfindungsgemäßen Leistungsmodule sind breit einsetzbar und zweckmäßig Bestandteil von Windkraftanlagen oder sonstigen Vorrichtungen. Insbesondere sind die Leistungsmodule nicht auf einen bestimmten Leistungsbereich beschränkt.

Das erfindungsgemäße Verfahren ist ein Verfahren zur Herstellung eines erfindungsgemäßen Leistungsmoduls wie zuvor beschrieben. Erfindungsgemäß wird bei dem Verfahren das zumindest eine Leistungsbauteil mittels folienunterstützten Gießens (engl. FAM: *"Film-Assisted-Molding"*) vergossen. Vorzugsweise wird bei dem erfindungsgemäßen Verfahren Isolationsmaterial und/oder zumindest ein Teil des Leiterrahmens mittels additiver Fertigung hergestellt. Gerade die additive Fertigung bietet eine hohe Flexibilität beim Aufbau von Leitungsverbindungen.

Die Leistungshalbleiter werden dazu in den folgenden Einzelprozessschritten lot- und sinterfrei elektrisch kontaktiert:
Dazu werden zunächst die Leistungshalbleiter zweckmäßig auf einer Trägerfolie angeordnet, was vorteilhafterweise sehr präzise möglich ist. Nachfolgend werden die Leistungsbauteile, etwa mittels folienunterstützten Gießens (engl. FAM: *"Film Assisted Molding")* miteinander vergossen.

Das resultierende Gussteil kann nachfolgend mit einer Metallisierung metallisiert werden, etwa strukturiert metallisiert, insbesondere mittels additiver Verfahren, vorzugsweise mittels galvanischer Verfahren und/oder Druckverfahren und/oder Sprühverfahren, werden. Die Metallisierung bildet leitende Verbindungen eines Leiterrahmens aus.

Auf die Metallisierung des Gussteils kann, insbesondere strukturiert, Isolationsmaterial aufgebracht werden. Insbesondere erfolgt das Aufbringen von Isolationsmaterial mittels additiver Verfahren, vorzugsweise mittels Druckverfahren und/oder Sprühverfahren. Das Isolationsmaterial bildet gemeinsam mit der vorangegangen, beschriebenen Metallisierung den Leiterrahmen aus.

Besonders bevorzugt werden die Verfahrensschritte von Metallisierung und Aufbringen von Isolationsmaterial mehrfach aufeinanderfolgend ausgeführt, sodass ein mehrlagiger Leiterrahmen ausgebildet wird. Mittels der Mehrlagentechnik lässt sich eine Vielzahl von weiteren Bauteilen elektrisch in das Leistungsmodul einbinden, etwa eine Treiberschaltung oder eine Kommunikationseinrichtung oder ein Messmittel wie ein Sensor, etc.

Nachfolgend wird die Erfindung anhand eines in der Zeichnung dargestellten Ausführungsbeispiels näher erläutert.

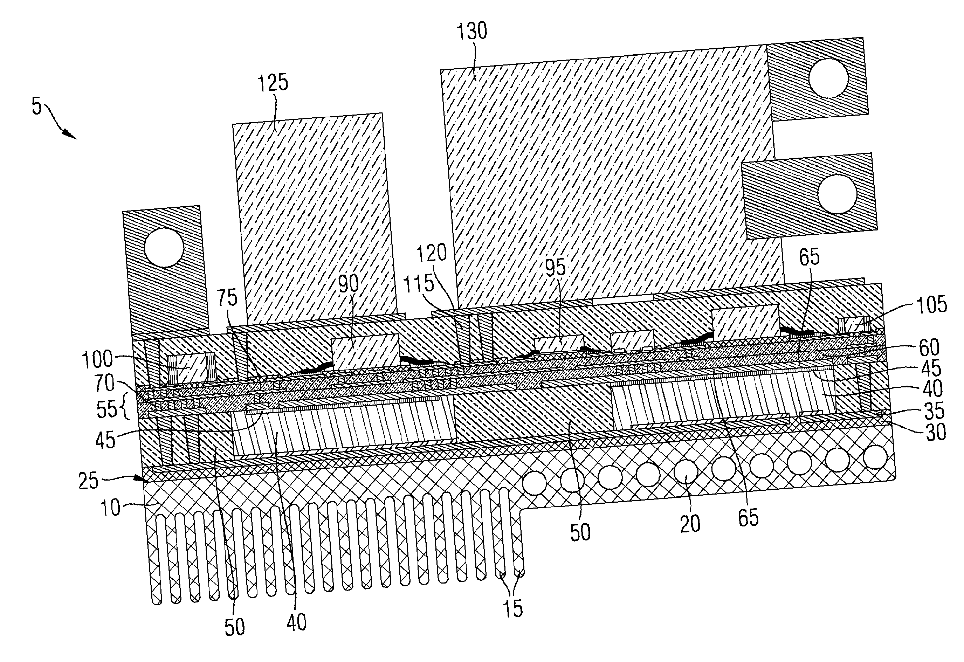

Die einzige Zeichnungsfigur
- Fig. 1: zeigt ein erfindungsgemäßes Leistungsmodul schematisch im Querschnitt.

Das in Fig. 1 dargestellte Leistungsmodul 5 ist bodenplattenlos ausgebildet und weist einen Kühler 10 auf, welcher mit Kühlfinnen 15 zur Durchströmung mit Luft sowie mit Kühlwasserdurchführungen 20 zur Durchströmung mit Kühlwasser versehen ist.

Der Kühler 10 weist eine Flachseite 25 auf. Auf die Flachseite 25 des Kühlers 10 ist eine gleichmäßig dünne, im dargestellten Ausführungsbeispiel weniger als 20 Mikrometer dicke, Schicht 30 eines wärmeleitenden Isolationsmaterials, hier eines wärmeleitenden Kunststoffs, aufgetragen. Diese Schicht 30 wärmeleitenden Isolationsmaterials ist oberflächlich mit einer strukturierten Kupferschicht 35 zur elektrischen Kontaktierung beschichtet.

An die Kupferschicht 35 sind Halbleiter-Leistungsbauteile in Form von Bare-Die-Chips 40, im dargestellten Ausführungsbeispiel IGBT-Bauteile (in weiteren Ausführungsbeispielen können stattdessen auch SiC- oder GaN-MOSFETS vorhanden sein), elektrisch leitend kontaktiert. Die Bare-Die-Chips 40 weisen jeweils eine von dem Kühler 10 abgewandte Flachseite auf, welche je mit einem oder mehreren elektrischen Chipkontakten 45 versehen ist.

Die Bare-Die-Chips 40 sind zu einem bei Normaldruck und Raumtemperatur festen Gussteil 50 vergossen, indem der zwischen den und an den Bare-Die-Chips 40 befindliche Freiraum von der Schicht 30 wärmeleitenden Isolationsmaterials oder der Kupferschicht 35 an bis hin zur Höhe der Chipkontakte 45 der Bare-Die-Chips 40 gefüllt ist. Vergossen wird bei der erfindungsgemäßen Herstellung des Leistungsmoduls 5 mit einem wärmeleitenden Kunststoff, der mit einer Kunststoffmatrix mit wärmeleitenden Partikeln, etwa aus Keramik oder Metall, gebildet ist. Dabei ist das Gussteil 50 mittels der wärmeleitenden Partikel zudem in seinem thermischen Ausdehnungskoeffizienten an jenen von weiteren, an das Material angrenzenden Teilen des Leistungsmoduls angeglichen. Das Gussteil 50 schließt mit der Oberfläche der Chipkontakte 45 der Bare-Die-Chips 40 bündig ab.

Das Gussteil 50 weist fern dem Kühler 10 eine ebene, d.h. insbesondere stufen- und krümmungslose, Oberfläche auf, welche zum Teil mit der Oberfläche der Chipkontakte 45 gebildet ist.

Auf diese Oberfläche ist ein mehrlagiger Leiterrahmen 55, im dargestellten Ausführungsbeispiel mittels eines additiven, d.h. generativen, Fertigungsverfahrens, angeordnet. Dazu wird bei der erfindungsgemäßen Herstellung des Leistungsmoduls 5 auf die Oberfläche des Gussteils 50 mittels 3D-Drucks eine strukturierte Kupfermetallisierung 65 aufgedruckt, welche die Chipkontakte 45 elektrisch kontaktiert. Grundsätzlich kann anstelle des 3D-Drucks auch eine andere additive Technik zum Einsatz kommen, beispielsweise das Sprühen. An Bereichen der Oberfläche des Gussteils 50, an welche keine Kupfermetallisierung 65 aufgedruckt ist, wird eine Isolierschicht 60 abgeschieden.

Auf der Kupfermetallisierung 65 und der Isolierschicht 60 wird nun die Isolierschicht 60 bis auf einige wenige Kupfervias 70, welche sich in Richtung vom Kühler 10 fort erstrecken, fortgesetzt, sodass die Kupfermetallisierung 65 in der Isolierschicht 60 eingebettet ist und in Dickenrichtung der Isolierschicht mittels der Kupfervias 70 elektrisch kontaktierbar ist. Die Isolierschicht 60 mit der Kupfermetallisierung 65 weist eine Dicke von - in diesem Ausführungsbeispiel - lediglich 30 Mikrometern auf und bildet eine erste Lage des mehrlagigen Leiterrahmens 55. In weiteren, nicht eigens dargestellten Ausführungsbeispielen kann die Dicke doppelt oder dreimal so groß sein.

Eine zweite Lage des mehrlagigen Leiterrahmens 55 wird durch Wiederholung derjenigen Prozessschritte gefertigt, wie sie in den beiden vorhergehenden Absätzen beschrieben sind. Dabei tritt an die Stelle der Oberfläche des Gussteils 50 die Oberfläche der ersten Lage des mehrlagigen Leiterrahmens 55 und die Kupfervias 70 treten an die Stelle der Chipkontakte 45. Dabei treten auch durch die zweite Lage des mehrlagigen Leiterrahmens 55 Kupfervias 70 hindurch, welche an der dem Kühler 10 fernen Seite der zweiten Lage des Leiterrahmens 55 mittels Kupfermetallisierungen 75 elektrisch kontaktierbar sind. Auch diese zweite Lage der des Leiterrahmens weist eine Dicke von lediglich 30 Mikrometern auf, sodass der mehrlagige Leiterrahmen 55 inklusive Kupfermetallisierungen 75 lediglich eine Dicke von weniger als 70 Mikrometern aufweist. In weiteren, nicht eigens dargestellten Ausführungsbeispielen können die beiden vorgenannten Dicken jeweils etwa doppelt so groß sein oder dreimal so groß sein.

An den mehrlagigen Leiterrahmen 55 sind an dessen dem Kühler 10 abgewandten Flachseite, also an der den Bare-Die-Chips 40 abgewandten Flachseite des Leiterrahmens 75, weitere Bauelemente des Leistungsmoduls 5 kontaktiert: Diese Bauelemente sind zum einen mehrere Gate-Drive-Units 90, eine Steuereinrichtungen 95, Kondensatoren 100, Widerstände 105 sowie ein Kommunikationsmodul 110 zur Funkübertragung von Daten. Diese Bauelemente sind an der dem Kühler 10 abgewandten Flachseite des mehrlagigen Leiterrahmens 55 mit wärmeleitfähigem Kunststoff - ähnlich wie die Bare-Die-Chips 40 - zu einem bei Raumtemperatur und Normaldruck festen Körper vergossen. Mehrere Kupfervias 115 erstrecken sich durch den wärmeleitfähigen Kunststoff hindurch an einen mit einer Kupfermetallisierung 120 metallisierten Außenbereich. Der Kunststoff schließt mit den Kupfermetallisierungen 120 bündig ab. An den Außenbereich sind in an sich bekannter Weise ein Filter 125 und ein DC-Link 130 des Leistungsmoduls 5 kontaktiert.

In weiteren, nicht eigens dargestellten Ausführungsbeispielen, welche im Übrigen dem vorstehend beschriebenen Ausführungsbeispiel entsprechen, ist die Schicht 30 wärmeleitenden Isolationsmaterials nicht vorhanden. In diesen Ausführungsbeispielen ist der Kühler 10 selbst mit elektrisch isolierendem Material gefertigt, sodass eine zusätzliche Schicht 30 isolierenden Materials verzichtbar ist.

Erfindungsgemäß wird das Leistungsmodul 5 mittels folienunterstützten Gießens hergestellt:
Dazu werden die Bare-Die-Chips 40 zunächst präzise auf einer Trägerfolie angeordnet. Nachfolgend werden die Bare-Die-Chips 40, etwa mittels folienunterstützten Gießens (engl. FAM: "Film Assisted Molding") miteinander vergossen. Das resultierende Gussteil wird nachfolgend mit der Kupfermetallisierung 65 wie oben beschrieben metallisiert.

Auf die Metallisierung des Gussteils wird, insbesondere strukturiert wie oben beschrieben, Isolationsmaterial 60 aufgebracht. Das Isolationsmaterial 60 bildet gemeinsam mit der vorangegangen beschriebenen Kupfermetallisierungen 65 den Leiterrahmen 55 aus.

Dazu werden die Verfahrensschritte von Metallisierung und Aufbringen von Isolationsmaterial 60 wie oben beschrieben mehrfach aufeinanderfolgend ausgeführt, sodass ein mehrlagiger Leiterrahmen 55 ausgebildet wird.

## Patentansprüche

1. Leistungsmodul mit mindestens einem Leistungsbauteil (40) und mit einem Leiterrahmen (55) und mit einer Steuereinrichtung (95), bei welchem der Leiterrahmen (55) ein Flachteil mit zwei Flachseiten umfasst, wobei das Leistungsbauteil (40) an einer der beiden Flachseiten und die Steuereinrichtung (95) an der anderen der beiden Flachseiten angeordnet ist.

2. Leistungsmodul nach dem vorhergehenden Anspruch, bei welchem das Leistungsbauteil (40) mit und/oder in und/oder zu einem Gussteil (50) des Leistungsmoduls vergossen ist und der Leiterrahmen (55) an dem Gussteil (50) angeordnet ist.

3. Leistungsmodul nach einem der vorhergehenden Ansprüche, bei welchem das Gussteil (50) bei 293 K und Normaldruck ein Festkörper ist.

4. Leistungsmodul nach einem der vorhergehenden Ansprüche, bei welchem der Leiterrahmen (55), vorzugsweise das Flachteil des Leiterrahmens (55), mit Metall, insbesondere mit Kupfer, gebildet ist.

5. Leistungsmodul nach einem der vorhergehenden Ansprüche, bei welchem der Leiterrahmen (55) mittels additiver Fertigung, insbesondere in Form von galvanischer Fertigung und/oder von Fertigung mittels Druckens und/oder mittels Sprühens, vorzugsweise an dem Gussteil des Leistungsmoduls nach Anspruch 2, angeordnet ist.

6. Leistungsmodul nach einem der vorhergehenden Ansprüche, bei welchem der Leiterrahmen (55) mehrlagig aufgebaut ist.

7. Leistungsmodul nach einem der vorhergehenden Ansprüche, bei welchem das Flachteil des Leiterrahmens (55) eine Dicke von höchstens 500 Mikrometern und vorzugsweise von höchstens 70 Mikrometern aufweist.

8. Leistungsmodul nach einem der vorhergehenden Ansprüche, welches bodenplattenlos ausgebildet ist.

9. Leistungsmodul nach einem der vorhergehenden Ansprüche, welches DCB-substratfrei und/oder PCT-substratfrei, insbesondere substratlos, ausgebildet ist.

10. Leistungsmodul nach einem der vorhergehenden Ansprüche, welches mindestens einen Kühlkörper (10) aufweist, welcher thermisch an zumindest eine Flachseite des Flachteils des Leiterrahmens (55) angebunden ist.

11. Verfahren zur Herstellung eines Leistungsmoduls nach einem der vorhergehenden Ansprüche, bei welchem das zumindest eine Leistungsbauteil (40) mittels folienunterstützten Gießens vergossen wird und wobei vorzugsweise Isolationsmaterial (60) und/oder zumindest ein Teil des Leiterrahmens (55) mittels additiver Fertigung hergestellt wird.
